**Europäisches Patentamt**

**European Patent Office**

**Office européen des brevets**

(19)

(11) Veröffentlichungsnummer : **0 036 384**
**B1**

(12)

# EUROPÄISCHE PATENTSCHRIFT

(45) Veröffentlichungstag der Patentschrift :
07.11.84

(51) Int. Cl.³ : **H 05 K  7/20**

(21) Anmeldenummer : **81730016.3**

(22) Anmeldetag : **13.02.81**

(54) **Gerätekombination für den Bergbau mit Bauelementen der Leistungselektronik.**

(30) Priorität : **14.03.80 DE 3010363**

(43) Veröffentlichungstag der Anmeldung :
**23.09.81 Patentblatt 81/38**

(45) Bekanntmachung des Hinweises auf die Patenterteilung : **07.11.84 Patentblatt 84/45**

(84) Benannte Vertragsstaaten :
**FR GB**

(56) Entgegenhaltungen :
**DE-A- 2 707 754**
**DE-B- 2 345 626**
**US-A- 3 676 745**
**US-A- 4 199 953**
**ELECTRONICS INTERNATIONAL, Band 53, Nr. 25, 1980, New York, T. MANUEL et al. "IBM's H Series Bows; Packaging Ups Speed" Seiten 41, 42**

(73) Patentinhaber : **Siemens Aktiengesellschaft**
**Berlin und München Wittelsbacherplatz 2**
**D-8000 München 2 (DE)**

(72) Erfinder : **Raschke, Klaus**
**Germersheimer Weg 84**
**D-1000 Berlin 20 (DE)**
Erfinder : **Hidde, Dieter**
**Gartenfelder Strasse 58**
**D-1000 Berlin 20 (DE)**
Erfinder : **Mrozik, Reinhold**
**Schillingstrasse 51**
**D-1000 Berlin 51 (DE)**

## Beschreibung

Die Erfindung befaßt sich mit einer Gerätekombination für den Bergbau unter Tage mit einem druckfesten Gehäuse und darin angeordneten Bauelementen der Leistungselektronik sowie Einrichtungen zur Abführung der Verlustwärme der Bauelemente durch ein flüssiges Kühlmittel.

Eine Gerätekombination dieser Art ist durch die DE-OS 27 07 754 bekannt geworden. Die Bauelemente der Leistungselektronik bilden bei der bekannten Gerätekombination zusammen mit der Kühlvorrichtung eine Baueinheit, die in dem druckfesten Raum angeordnet ist. Die zu- und Ableitung des Kühlmittels geschieht über einzelne druckfeste Rohrdurchführungen oder einen die benötigten Verbindungen aufweisenden Flansch. In beiden Fällen durchströmt das Kühlmittel einen in dem druckfesten Raum befindlichen Kühlkörper.

Der Erfindung liegt die Aufgabe zugrunde, die Bauelemente der Leistungselektronik ohne Durchleitung des flüssigen Kühlmittels durch den druckfesten Raum zu kühlen und dennoch einen guten Wärmeübergang von den Bauelementen zu dem Kühlmittel zu erreichen.

Gemäß der Erfindung wird diese Aufgabe bei einer Gerätekombination der eingangs genannten Art dadurch gelöst, daß sich die Montagefläche der zu kühlenden Bauelemente an der dem druckfesten Raum zugewandten Seite eines eine Öffnung des druckfesten Gehäuses verschließenden Kühlkörpers befindet, dessen dem druckfesten Raum abgewandte Außenseite einen Ansatz mit Kanälen zur Durchleitung des Kühlmittels aufweist. Der Kühlkörper begrenzt somit den druckfesten Raum und ist Träger der Leistungshalbleiter. Bei druckfesten Gehäusen mit quaderförmiger Gestalt, z. B. nach der DE-PS 18 01 062, kann die Öffnung z. B. an einer Seitenfläche vorgesehen sein, an der sich üblicherweise druckfeste Leitungsdurchführungen befinden.

Im Rahmen der Erfindung können die in zwei Ebenen angeordneten Kanäle durch den Kühlkörper durchsetzende Bohrungen gebildet sein, und die Bohrungen jeder der beiden Ebenen können zur Schaffung eines mäanderförmigen Fließweges des Kühlmittels stirnseitig durch Überleitungsrohre verbunden sein. Diese Anordnung eignet sich besonders für als Gußstücke ausgebildete Kühlkörper und ist leicht herstellbar. Sie führt zu einer guten Kühlwirkung, weil sich ein relativ langer Weg des Kühlmittels durch den Kühlkörper ergibt und die Überleitungsrohre nur einen kleinen Teil dieses Weges beanspruchen.

Für die zuverlässige Kühlung der Bauelemente der Leistungselektronik, z. B. Thyristoren, kommt es auf einen guten Wärmeübergang zwischen den Bauelementen und ihrer Montagefläche an. Die Montagefläche soll daher möglichst eben sein. Benötigt man jedoch eine größere Anzahl von Bauelementen und eine entsprechend große Montagefläche, z. B. in der Größe 40 × 60 cm, so bereitet es erhebliche Schwierigkeiten, die gewünschte Ebenheit und Oberflächengüte einzuhalten. In Weiterbildung der Erfindung läßt sich diese Schwierigkeit jedoch dadurch beheben, daß die Montagefläche des Kühlkörpers, an der die Bauelemente der Leistungselektronik angebracht werden sollen, durch rinnenartige Vertiefungen in Teilflächen unterteilt ist, die durch Bearbeitung geebnet und geglättet sind. Bei dieser Anordnung kommt es nur darauf an, daß jede der Teilflächen in sich eben und glatt ist. Dagegen ist ein geringfügiger Versatz zwischen den Teilflächen oder eine geringfügige gegenseitige Neigung ohne weiteres zu dulden. Die präzise Bearbeitung kleiner Teilflächen ist aber im Vergleich zu der Bearbeitung großer Flächen wesentlich einfacher.

Die Größe der Teilflächen kann in zweckmäßiger Weise den Bauelementen der Leistungselektronik bzw. Baugruppen solcher Elemente angepaßt sein. Es dann daher z. B. für jeden Thyristor einer aus mehreren Thyristoren bestehenden Schaltungsanordnung eine Teilfläche vorgesehen sein.

Die Erfindung wird im folgenden anhand der Figuren näher erläutert.

Die Figur 1 zeigt eine druckfest gekapselte Gerätekombination mit einem Kühlkörper perspektivisch in vereinfachter Darstellung.

Die Figur 2 zeigt den Kühlkörper gemäß der Fig. 1 in der Seitenansicht.

Die Figur 3 zeigt die Draufsicht auf die Außenseite eines Kühlkörpers.

Die Figur 4 zeigt die Draufsicht auf die dem druckfesten Raum der Gerätekombination gemäß der Fig. 1 zugewandte Seite des Kühlkörpers.

In der Figur 5 ist der Kühlkörper von oben gezeigt, um die Lage der Rohranschlüsse erkennbar zu machen.

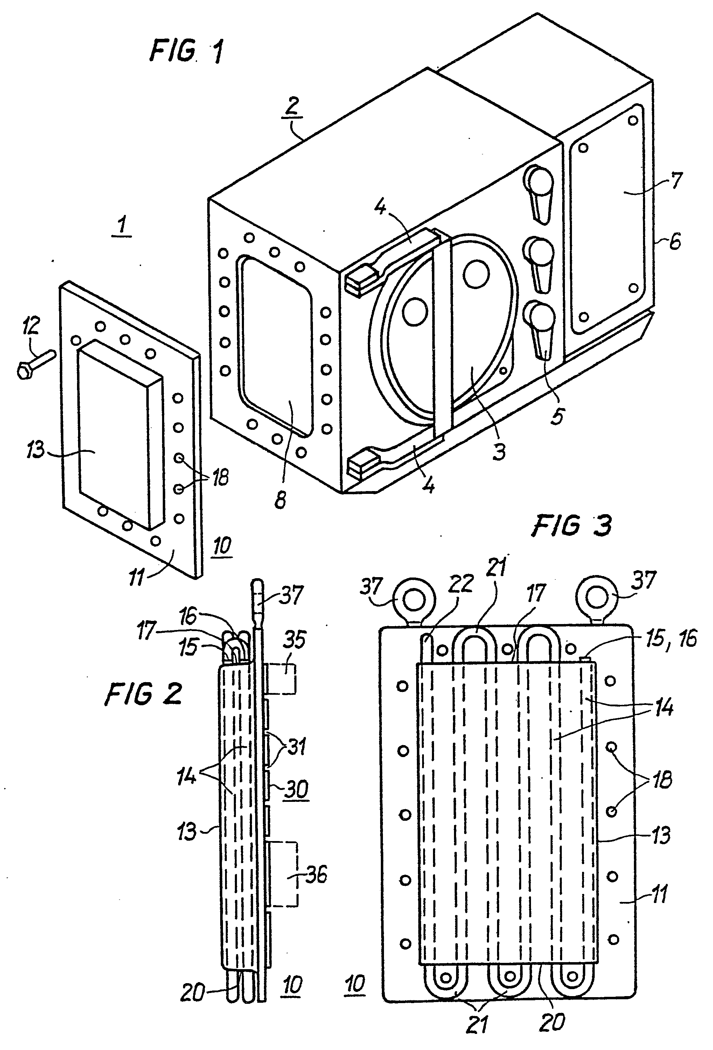

Die in der Fig. 1 dargestellte Gerätekombination 1 umfaßt ein quaderförmiges druckfestes Gehäuse 2, das aus Stahlblechteilen zusammengeschweißt sein kann. Eine vordere Gehäuseöffnung ist durch einen runden Deckel 3 verschlossen, der an Schwenkarmen 4 gehalten ist und der sich nach Aufhebung der vorgesehenen Verriegelungen durch Drehen und seitliches Schwenken öffnen läßt. An der Vorderwand des druckfesten Gehäuses 2 befinden sich neben dem Deckel 3 noch Betätigungshandgriffe 5 für Trennschalter. An der rechten Seite des druckfesten Gehäuses 2 ist ein Anschlußkasten 6 mit einem Verschlußdeckel 7 angebracht. In dem Anschlußkasten 6 befinden sich in bekannter Weise die äußeren Klemmstellen von druckfesten Leitungsdurchführungen, die in die Seitenwand des druckfesten Gehäuses 2 eingesetzt sind. Über dieses Durchführungen erfolgt die netzseitige Einspeisung der Gerätekombination 1 und der Anschluß der nicht dargestellten Verbraucher. Im vorliegenden Fall sind als Verbraucher Motoren von Betriebsmitteln des Untertage-Bergbaus vorgesehen, z. B. an Gewinnungs- oder Fördereinrichtungen, und es soll das Drehmoment und/oder die Drehzahl dieser Motoren gesteuert oder geregelt werden. Hierzu enthält die Gerätekombination 1 neben den für eine normale Steuerung von Motoren benötigten Schaltgeräten wie Trennschalter, Schütze, Schmelzsicherungen sowie Steuer- und Überwachungseinrichtungen noch Bauelemente der Leistungselektronik, z. B. Thyristoren. Diese können z. B. so gesteuert werden, daß sich ein allmählich ansteigendes Drehmoment bei der Inbetriebsetzung eines Förderbandes ergibt.

Die für Steuerungen oder Regelungen der angedeuteten Art benötigten Bauelemente der Leistungselektronik, zu denen Thyristoren und Triacs und die zu ihrer Ansteuerung benötigten Halbleiter zu rechnen sind, befinden sich, soweit bei ihrem Betrieb eine nennenswerte Verlustwärme anfällt, auf einem Kühlkörper 10, der etwa die Gestalt einer rechteckigen Platte mit einem flanschartigen Rand 11 aufweist und der an einer in der Fig. 1 gezeigten flanschartigen Öffnung 8 des druckfesten Gehäuses 2 mittels Schrauben 12 befestigt ist. Der Aufbau des Kühlkörpers 10 wird im folgenden anhand der Fig. 2 bis 5 erläutert.

Der Kühlkörper 10 ist ein aus Rotguß hergestelltes Gußstück. Rotguß ist eine Kupferlegierung, die neben etwa 80 bis 90 % Kupfer noch Zinn und Zink enthält und zusätzlich Blei enthalten kann, beispielsweise ist ein als Rg10 bezeichneter Rotguß aus etwa 10 % Zinn, 4 % Zink und 86 % Kupfer zusammengesetzt, während der Rotguß Rg5 etwa 5 % Zinn, 7 % Zink, 3 % Blei und 85% Kupfer enthält.

Der Kühlkörper 10 weist einen gegenüber dem flanschartigen und mit Schraubenlöchern 18 versehenen Rand 11 zurückgesetzten, etwa quaderförmigen Ansatz 13 auf, in dem sich in den Fig. 2 und 3 gestrichelt angedeutete Kühlkanäle 14 befinden. Wie die Fig. 2 zeigt, liegen die Kühlkanäle 14 in zwei Ebenen hintereinander. Eine Öffnung 15 für die Zuführung eines flüssigen Kühlmittels, z. B. Wasser, und eine weitere Öffnung 16 für die Ableitung des Kühlmittels befinden sich am Rande der oberen Schmalseite des Ansatzes 13. Die an dieser Schmalseite und der gegenüberliegenden Schmalseite 20 mündenden Bohrungen, welche die Kühlkanäle 14 bilden, sind durch gebogene Rohrstücke 21 derart verbunden, daß sich ein mäanderförmiger Fließweg des Kühlmittels durch den Kühlkörper 10 ergibt. Das Rohrstück 22 verbindet dabei die innere mit der äußeren Ebene von Kühlkanälen. Wie in der Fig. 5 durch die Pfeile 23 angedeutet ist, ergibt sich dadurch, wenn man von der überlagerten Mäanderform des Kühlweges absieht, einen Umkehr der Fließrichtung, so daß der Kühlkörper 10 im Gegenstromprinzip durchflossen wird. Dieses trägt zu einer Vergleichmäßigung der Temperaturverteilung in dem Kühlkörper 10 während des Betriebes der Leistungshalbleiter bei.

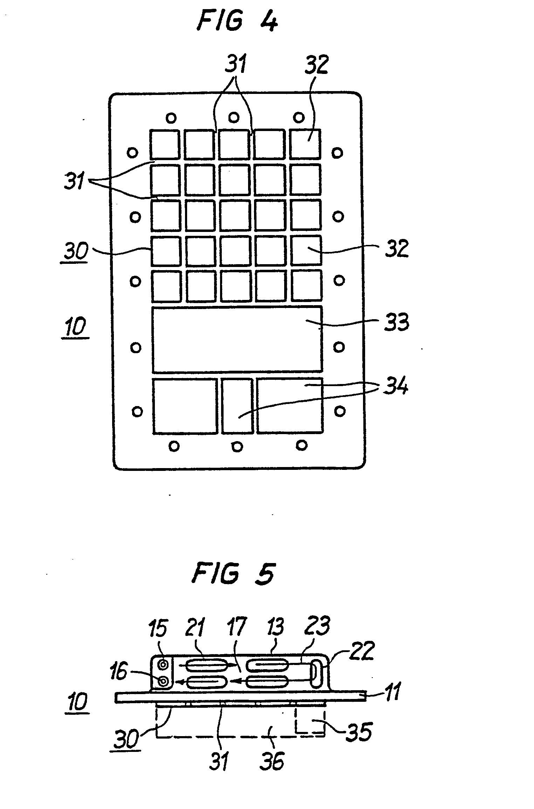

An seiner dem druckfesten Raum zugewandten Seite, d. h. seiner Innenseite, ist der Kühlkörper 10 mit einer Montagefläche 30 für die zu kühlenden Bauelemente versehen. Die Montagefläche 30 ist durch einander rechtwinklig kreuzende rinnenartige Vertiefungen 31 in eine Anzahl von Teilflächen unterschiedlicher Größe aufgeteilt. Dabei nehmen den oberen Teil der Montagefläche 30 insgesamt fünfundzwanzig Teilflächen 32 ein (Fig. 4), die jeweils für einen Leistungshalbleiter 35, z. B. einen Thyristor, vorgesehen sind (Fig. 5). Unterhalb dieses Bereiches befindet sich eine größere zusammenhängende Teilfläche 33, die sich z. B. mit einer vormontierten Halbleiterbaugruppe 36 bestücken läßt. Ähnlichen Zwekken dienen die unterhalb der Teilfläche 33 befindlichen weiteren Teilflächen 34. Jede der genannten Teilflächen ist in sich derart geebnet und geglättet, daß sich ein möglichst guter Wärmeübergang von den Gehäusen der Halbleiterbauelemente zu dem Kühlkörper 10 ergibt. Infolge der Unterteilung der gesamten Montagefläche 30 in die Teilflächen können diese nacheinander mit großer Genauigkeit bearbeitet werden. Dabei kommt es nicht auf einen Versatz oder eine geringe Abweichung der gegenseitigen Winkelstellung an. Infolge der Unterteilung kann auch eine Verspannung oder/eine geringfügige Verformung des gesamten Kühlkörpers kaum Einfluß auf die Teilflächen haben. Vielmehr nehmen die rinnenartigen Vertiefungen 31 solche Deformationen auf. Abweichend von dem gezeigten Beispiel kann die Montagefläche 30 auch in größere oder kleinere Teilflächen unterteilt sein. Dabei können auch von der Quadrat- oder Rechteckform verschiedene Formen der Teilflächen vorteilhaft sein.

Wie die vorstehende Beschreibung zeigt, ist der neue Kühlkörper für Bauelemente der Leistungselektronik, ausgehend von einem Gußstück, durch übliche mechanische Bearbeitungsgänge herstellbar. Er bildet dann in der Ausführung für quaderförmige Gehäuse ein plattenförmiges Bauteil, das als Verschlußorgan auf eine flanschartige Öffnung eines druckfesten Gehäuses aufsetzbar ist. Das Kühlmittel durchströmt nur den Kühlkörper und wird daher nicht durch Rohrleitungen oder sonstige Verbindungsmittel irgendwelcher Art durch den druckfesten Raum hindurchgeleitet. Auf diese Weise wird das Kühlmittel mit Sicherheit von den Geräten ferngehalten, die in dem Druckfesten Raum eingebaut sind. Dennoch wird das Kühlmittel durch die in den Kühlkörper eingearbeiteten Kanäle und die auf einfache Weise mit hoher Oberflächengüte zu bearbeitenden Montageflächen für die elektronischen Bauelemente günstig ausgenutzt.

Eine vorteilhafte Erleichterung beim Einbau der Leistungshalbleiter ergibt sich dadurch, daß diese außerhalb des druckfesten Raumes an dem Kühlkörper montiert werden können, wobei u. U. bereits ein Teil der zur Steuerung benötigten Leitungen angeschlossen werden kann. Anschließend wird der komplette Kühlkörper mit den Bauelementen an die Öffnung 8 (Fig. 1) angesetzt und befestigt. Um diesen Vorgang zu erleichtern, sind an der oberen Schmalseite des flanschartigen Randes 11 zwei Kranösen 37 angebracht (Fig. 2 und 3).

## Ansprüche

1. Gerätekombination für den Bergbau unter Tage mit einem druckfesten Gehäuse und darin angeordneten Bauelementen der Leistungselektronik sowie Einrichtungen zur Abführung der Verlustwärme der Bauelemente durch ein flüssiges Kühlmittel, dadurch gekennzeichnet, daß sich die Montagefläche (30) der zu kühlenden Bauelemente (35, 36) an der dem druckfesten Raum zugewandten Seite eines eine Öffnung (8) des druckfesten Gehäuses (2) verschließenden Kühlkörpers (10) befindet, dessen dem druckfesten Raum abgewandte Außenseite einen Ansatz (13) mit Kanälen (14) zur Durchleitung des Kühlmittels aufweist.

2. Gerätekombination nach Anspruch 1, dadurch gekennzeichnet, daß die in zwei Ebenen angeordneten Kanäle (14) durch den Kühlkörper (10) durchsetzende Bohrungen gebildet sind und daß die Bohrungen jeder der beiden Ebenen zur Schaffung eines mäanderförmigen Fließweges des Kühlmittels stirnseitig durch Überleitungsrohre (21, 22) verbunden sind.

3. Gerätekombination nach Anspruch 1, dadurch gekennzeichnet, daß die dem druckfesten Raum zugewandte Montagefläche (30) des Kühlkörpers (10) durch rinnenartige Vertiefungen (31) in Teilflächen (32, 33, 34) unterteilt ist, die durch Bearbeitung geebnet und geglättet sind.

4. Gerätekombination nach Anspruch 3, dadurch gekennzeichnet, daß die Größe der Teilflächen (32, 33, 34) den Bauelementen der Leistungselektronik (35) bzw. Baugruppen (36) solcher Elemente angepaßt ist.

## Claims

1. A device combination for underground mining having a pressure-resistant housing and power electronics components arranged therein, as well as devices for removing the heat loss of the components by a liquid coolant, characterised in that the mounting surface (30) for the components (35, 36) to be cooled, is located on the side, of a cooling body (10) which faces the pressure-resistant chamber, which cooling body closes an opening (8) in the pressure-resistant housing (2) and the outer side of which facing away from the pressure-resistant chamber, has a projection (13) having channels (14) for passage of the coolant.

2. A device combination according to Claim 1, characterised in that the channels (14), which are arranged in two planes, are formed by bores which pass through the cooling body (10) ; and that in order to create a serpentine flow path for the coolant, the bores of each of the two planes are connected at the end faces by means of connecting pipes (21, 22).

3. A device combination according to Claim 1, characterised in that the mounting surface (30) of the cooling body (10), which faces the pressure-resistant chamber, is divided into sub-surfaces (32, 33, 34) by groove-shaped recesses (31), which sub-surfaces are levelled and smoothed by working.

4. A device combination according to Claim 3, characterised in that the size of the sub-surfaces (32, 33, 34) is matched to the power electronics components (35) and to assemblies (36) of such components.

## Revendications

1. Combinaison d'appareils pour l'exploitation de mines souterraines, comportant un boîtier résistant à la pression et des composants de l'électronique de puissance qui s'y trouvent et des dispositifs pour évacuer la chaleur dissipée des composants à l'aide d'un milieu réfrigérant liquide, caractérisé par le fait que la surface de montage (30) des composants (35, 36) à refroidir se trouve sur le côté, voisin de l'espace résistant à la pression, d'un corps refroidisseur (10) obturant une ouverture (8) du boîtier (2) résistant à la pression, et dont le côté extérieur, qui est éloigné de la chambre résistant à la pression, présente un appendice (13) avec des canaux (14) pour le passage du milieu réfrigérant.

2. Combinaison d'appareils selon la revendication 1, caractérisée par le fait que les canaux (14) disposés dans deux plans sont formés par des perçages traversant le corps refroidisseur (10), et que les perçages de chacun des deux plans sont reliés frontalement par des conduites de traversée (21, 22) pour former, pour le milieu réfrigérant, des voies d'écoulement en forme de méandres.

3. Combinaison d'appareils selon la revendication 1, caractérisée par le fait que la surface de montage (30) du corps refroidisseur (10), qui est tournée vers la chambre résistant à la pression est subdivisée par des dépressions (31) en forme de rigoles, en surface partielles (32, 33, 34) qui sont aplanies et lissées par traitement.

4. Combinaison d'appareils selon la revendication 3, caractérisée par le fait que les surfaces partielles (32, 33, 34) sont adaptées aux composants de l'électronique de puissance (35) ou aux modules de tels composants.

*FIG. 1*

2

1

4

7

6

12

13

18

11

10

8

3

5

4

*FIG 3*

*FIG 2*

37

17  16

15

35

31

14

30

13

36

20

10

37  22  21  17

15, 16

14

18

13

11

10

21  20

## FIG 4

## FIG 5